# EUROPEAN PATENT APPLICATION

(11) **EP 2 741 594 A1**
(43) Date of publication of application: **11.06.2014**
(21) Application number: 13770617.2
(22) Date of filing: 07.04.2013
(51) Int. Cl.: H05K 7/14

(54) **BACKPLANE, CABINET-GRADE COMMUNICATION DEVICE, AND BACKPLANE REPLACEMENT METHOD**

(30) Priority: 05.11.2012 CN 201210436126
(71) Applicant: Huawei Technologies Co., Ltd., Shenzhen, Guangdong 518129 (CN)
(72) Inventor: BAI, Lei, Shenzhen, Guangdong 518129 (CN); AO, Feng, Shenzhen, Guangdong 518129 (CN); LUO, Fei, Shenzhen, Guangdong 518129 (CN)
(74) Representative: Goddar, Heinz J.
(86) International application number: PCT/CN2013/073791
(87) International publication number: WO 2014/067257

(57) **Abstract**

Embodiments of the present invention disclose a backplane, a cabinet-level communication device, and a method for replacing a backplane, relate to the field of mobile communication technologies, and can greatly reduce difficulty in replacing a backplane while ensuring stability of a connection between the backplane and a front board or a rear board. The backplane includes: a base plate of a stripe structure; one or more first connectors arranged on a first face of the base plate and configured to connect a corresponding connector on a front board; and one or more second connectors arranged on a second face of the base plate opposite to the first face and configured to connect a corresponding connector on a rear board. The backplane is fixed and arranged in a detachable manner on the rear board or the front board and can be plugged or unplugged along with the rear board that fixes the backplane or the front board that fixes the backplane. The rear board is connected to the front board in an orthogonal connection manner through the backplane.

## Description

### TECHNICAL FIELD

The present invention relates to the field of communication technologies, and in particular to a backplane, a cabinet-level communication device, and a method for replacing a backplane.

### BACKGROUND

With rapid development of the Internet and cloud computing, a requirement for a communication device, which serves as a major hardware implementation scheme in terms of engineering, is also rapidly growing. As a major form of a network communication device, a cabinet-level communication device has various advantages over a rack-mounted communication device, a tower-mounted communication device, a blade communication device, and the like.

A backplane is an indispensable component of the cabinet-level communication device. A front board and a rear board of the cabinet-level communication device are effectively connected by the backplane. Generally, the backplane is arranged in the innermost of the cabinet-level communication device.

In a process of implementing the present invention, the inventor finds the following problem: In the prior art, the backplane is directly fixed on a rack of the cabinet-level communication device, and multiple screws used to fix and connect the backplane to the cabinet-level communication device are arranged on the backplane, thereby making it more difficult to assemble or disassemble the backplane; and when the cabinet-level communication device is faulty, generally the cabinet-level communication device has to be sent to a manufacturer to get disassembled and repaired by a professional technician, and generally cannot be changed or maintained by a user, thereby making it more difficult for the user to maintain the cabinet-level communication device, increasing a cost of using the cabinet-level communication device, and degrading use experience of the user.

### SUMMARY

Embodiments of the present invention provide a backplane, a cabinet-level communication device, and a method for replacing a backplane, so as to resolve great difficulty in maintaining a cabinet-level communication device in the prior art.

According to a first aspect of the present invention, a backplane is provided and applies to a cabinet-level communication device. The backplane includes:
a base plate of a stripe structure;
one or more first connectors, where the first connector is arranged on a first face of the base plate and configured to connect a corresponding connector on a front board; and
one or more second connectors, where the second connector is arranged on a second face of the base plate opposite to the first face and configured to connect a corresponding connector on a rear board.

The backplane is fixed and arranged in a detachable manner on the rear board or the front board and can be plugged or unplugged along with the rear board that fixes the backplane or the front board that fixes the backplane.

The rear board is connected to the front board in an orthogonal connection manner through the backplane.

In a first possible implementation manner of the first aspect, when the backplane is fixed and arranged on the rear board, the second connector of the backplane is connected to the corresponding connector on the rear board, and the rear board and the backplane are vertically placed in the cabinet-level communication device; and
the front board is horizontally placed in the cabinet-level communication device, the backplane is orthogonally connected to the front board, and the first connector of the backplane is connected to the corresponding connector on the front board.

In a second possible implementation manner of the first aspect, when the backplane is fixed and arranged on the front board, the first connector of the backplane is connected to the corresponding connector on the front board, and the front board and the backplane are horizontally placed in the cabinet-level communication device; and
the rear board is vertically placed in the cabinet-level communication device, the backplane is orthogonally connected to the rear board, and the second connector of the backplane is connected to the corresponding connector on the rear board.

In a third possible implementation manner of the first aspect, the first connector and the second connector are integrated.

In a fourth possible implementation manner of the first aspect, a screw hole is opened on the backplane to fix and arrange the backplane in a detachable manner on the rear board or the front board.

In the technical solutions of this embodiment, a backplane is provided. The backplane has a stripe structure and has a small size. No cooling hole needs to be arranged on the backplane, and heat dissipation can be implemented simply through the space between backplanes. This improves mechanical strength of the backplane and ensures a service life of the backplane while ensuring the effect of heat dissipation. In addition, the backplane is fixed and arranged in a detachable manner on the rear board or the front board and can be plugged or unplugged along with the rear board that fixes the backplane or the front board that fixes the backplane, thereby reducing difficulty in replacing the backplane. This further reduces difficulty in maintaining, by a user, a cabinet-level communication device arranged with the backplane and reduces a maintenance cost, and improves use experience of the user.

According to a second aspect of the present invention, a cabinet-level communication device is provided and includes a front board, a rear board, and a backplane. The backplane includes:
a base plate of a stripe structure;
one or more first connectors, where the first connector is arranged on a first face of the base plate and configured to connect a corresponding connector on a front board; and
one or more second connectors, where the second connector is arranged on a second face of the base plate opposite to the first face and configured to connect a corresponding connector on a rear board.

The backplane is fixed and arranged in a detachable manner on the rear board or the front board and can be plugged or unplugged along with the rear board that fixes the backplane or the front board that fixes the backplane.

The rear board is connected to the front board in an orthogonal connection manner through the backplane.

In a first possible implementation manner of the second aspect, when the backplane is fixed and arranged on the rear board, the second connector of the backplane is connected to the corresponding connector on the rear board, and the rear board and the backplane are vertically placed in the cabinet-level communication device; and
the front board is horizontally placed in the cabinet-level communication device, the backplane is orthogonally connected to the front board, and the first connector of the backplane is connected to the corresponding connector on the front board.

In a second possible implementation manner of the second aspect, a position of the first connector of the backplane is arranged correspondingly according to distribution of the front board.

In a third possible implementation manner of the second aspect, when the backplane is fixed and arranged on the front board, the first connector of the backplane is connected to the corresponding connector on the front board, and the front board and the backplane are horizontally placed in the cabinet-level communication device; and
the rear board is vertically placed in the cabinet-level communication device, the backplane is orthogonally connected to the rear board, and the second connector of the backplane is connected to the corresponding connector on the rear board.

In a fourth possible implementation manner of the second aspect, a position of the second connector of the backplane is arranged correspondingly according to distribution of the rear board.

In a fifth possible implementation manner of the second aspect, the first connector and the second connector are integrated.

In a sixth implementation manner of the second aspect, a screw hole is opened on the backplane.

In a seventh possible implementation manner of the second aspect, the cabinet-level communication device further includes a metal support, where a through hole is opened on the metal support to match the first connector or the second connector of the backplane; several screw holes are further arranged on the metal support to fix and connect the backplane, the front board, or the rear board; and the metal support is configured to fix and arrange the backplane on the front board or the rear board.

In the technical solutions of this embodiment, a cabinet-level communication device is provided. The cabinet-level communication device includes a backplane. The backplane has a stripe structure and has a small size. No cooling hole needs to be arranged on the backplane, and heat dissipation can be implemented simply through the space between backplanes. This improves mechanical strength of the backplane and ensures a service life of the backplane while ensuring the effect of heat dissipation. In addition, the backplane is fixed and arranged in a detachable manner on the rear board or the front board and can be plugged or unplugged along with the rear board that fixes the backplane or the front board that fixes the backplane, thereby reducing difficulty in replacing the backplane. This further reduces difficulty in maintaining, by a user, the cabinet-level communication device and reduces a maintenance cost, and improves use experience of the user.

According to a third aspect of the present invention, a method for replacing a backplane is provided. The method applies to a cabinet-level communication device. The communication device includes: a cabinet, and a front board, a rear board, and the backplane inside the cabinet, where the front board and the rear board are connected through the backplane. The method includes:
when the backplane is faulty, unplugging the front board fixed with the backplane or the rear board fixed with the backplane from the cabinet;
detaching the faulty backplane from the front board fixed with the backplane or the rear board fixed with the backplane, and replacing it with a normal backplane; and
plugging the front board fixed with the normal backplane or the rear board fixed with the normal backplane after the replacement back into the cabinet.

In the technical solutions of this embodiment, a method for replacing a backplane is provided. The method for replacing a backplane features a simple operation and a small number of steps, and a user can replace the backplane on his or her own without needing any help of a professional person, thereby reducing a cost of maintaining a cabinet-level communication device arranged with the backplane and improving use experience of the user.

### BRIEF DESCRIPTION OF DRAWINGS

FIG. 1 is a first schematic structural diagram of a backplane according to an embodiment of the present invention;
FIG. 2 is a schematic structural diagram of a backplane in the prior art;
FIG. 3 is a first schematic assembly diagram of a cabinet-level communication device according to an embodiment of the present invention;
FIG. 4 is a second schematic assembly diagram of a cabinet-level communication device according to an embodiment of the present invention;
FIG. 5 is a schematic installation diagram of a backplane according to an embodiment of the present invention;
FIG. 6 is a second schematic structural diagram of a backplane according to an embodiment of the present invention;
FIG. 7 is a third schematic assembly diagram of a cabinet-level communication device according to an embodiment of the present invention;
FIG. 8 is a schematic assembly diagram of a backplane arranged on a metal support according to an embodiment of the present invention;
FIG. 9 is a schematic assembly diagram of a backplane assembled on a rear board according to an embodiment of the present invention; and
FIG. 10 is a flowchart of a method for replacing a backplane according to an embodiment of the present invention.

Signs of the accompanying drawings are described as follows:
1 - Backplane 10 - Base plate 11 - First connector
12 - Second 13 - Screw hole 2 - Cabinet-level communication device connector
21 - Front board 22 - Rear board 23 - Fan
3 - Metal support

### DESCRIPTION OF EMBODIMENTS

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

### Embodiment 1

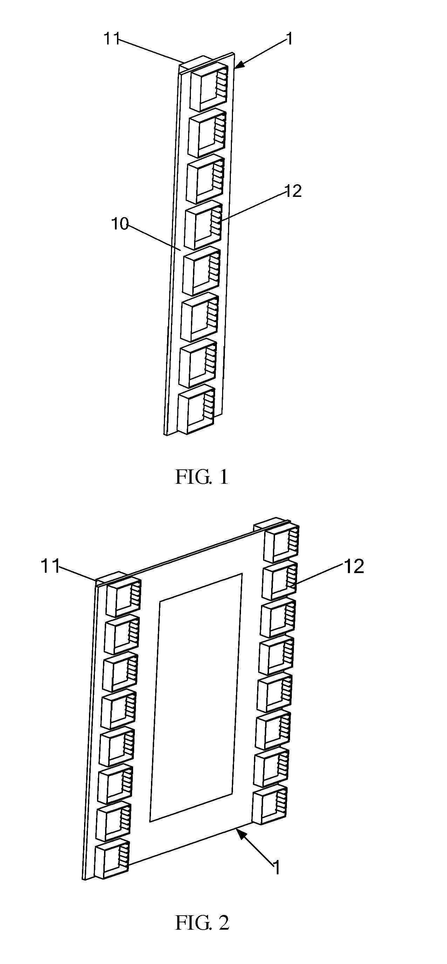

This embodiment of the present invention provides a backplane 1. The backplane 1 applies to a cabinet-level communication device. As shown in FIG. 1, the following are included:
a base plate 10 of a stripe structure;
one or more first connectors 11, where the first connector 11 is arranged on a first face of the base plate 10 and configured to connect a corresponding connector on a front board; and
one or more second connectors 12, where the second connector 12 is arranged on a second face of the base plate 10 opposite to the first face and configured to connect a corresponding connector on a rear board.

The rear board is connected to the front board in an orthogonal connection manner through the backplane. The connection may be a physical connection or an electrical connection, and cabling is arranged inside the backplane 1, so that functions such as data exchange and signal transfer can be implemented between the rear board and the front board.

As shown in FIG. 2, generally, the backplane 1 in the prior art has a plate structure, and two or more columns of connectors are arranged on each face of the backplane 1. For ease of description, a face on which a first connector is arranged is called the first face, and another face on which a second connector is arranged is called the second face. The first connector 11 on the first face is configured to connect to a connector on the front board 21, and the second connector 12 on the second face is configured to connect a connector on the rear board 22. During installation, generally, the backplane 1 is first fixed and arranged on a shelf of a cabinet-level communication device 2, and then, the front board 21 and the rear board 22 are connected to corresponding connectors of the backplane 1, respectively, to implement a data connection between the front board 21 and the rear board 22.

In the technical solutions of the present invention, as shown in FIG. 1, the base plate of the backplane 1 has a stripe structure. The so-called stripe structure is a stripe structure compared with a backplane in the prior art. As can be seen from the comparison between FIG. 1 and FIG. 2, a length and a width of the backplane 1 shown in FIG. 1 according to the present invention are relatively large, and generally, a size of the first face of the backplane 1 according to the present invention allows only one column of the first connectors to be arranged; and similarly, a size of the second face of the backplane 1 according to the present invention allows only one column of the second connectors to be arranged. This is different from the backplane 1 in the prior art.

In addition, the backplane 1 is fixed and arranged in a detachable manner in advance on the rear board 22 or the front board 21, and then, can be plugged or unplugged along with the rear board 22 that fixes the backplane 1 or the front board 2 that fixes the backplane 1, instead of being installed on a shelf in the prior art, thereby simplifying installation steps of the backplane 1.

Generally, when the front board 21 and the rear board 22 of the cabinet-level communication device 2 are working, plenty of heat is radiated. Therefore, in the prior art, generally, at least one cooling hole 13 of a varied size is arranged on the backplane 1, so that the heat can be rapidly dissipated to another place. Arranging the cooling hole 13, however, reduces the overall mechanical strength of the backplane 1 and causes the backplane 1 to be easily damaged, thereby affecting a service life of the backplane 1.

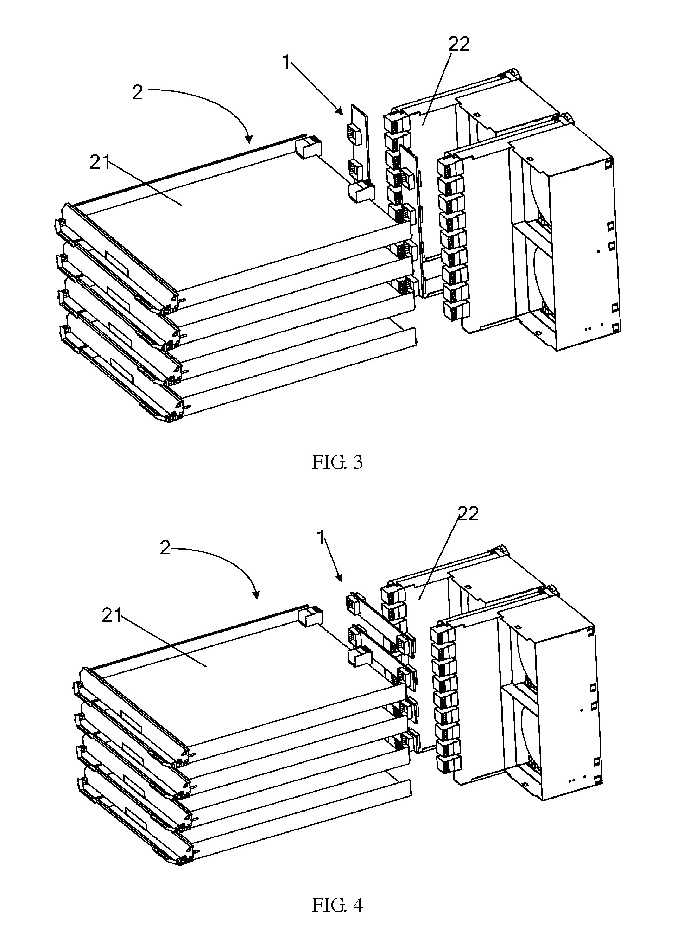

In the technical solutions of the present invention, the backplane 1 has a stripe structure and its size, especially a longitudinal size, is relatively small as compared with a backplane 2 in the prior art. As shown in FIG. 3, when multiple backplanes 1 are arranged between the front board 21 and the rear board 22 of the cabinet-level communication device 2, because the space between the backplanes 1 is large and can be used for heat dissipation of the cabinet-level communication device 2, no cooling hole needs to be arranged on the backplane 1 as compared with the prior art, thereby improving the mechanical strength of the backplane 1. This further improves the service life of the backplane 1, reduces a complexity requirement of the backplane 1 in terms of a production process, and lowers a manufacturing cost of the backplane 1.

During installation, as shown in FIG. 3, first, the second connector 12 of the backplane 1 may be matched and connected to the corresponding connector on the rear board 22; then, the backplane 1 is fixed and arranged on the rear board 22 by using one or more fixtures (such as a screw, a bolt, or the like); then, the rear board 22 arranged with the backplane 1 is arranged in a corresponding position of the cabinet-level communication device 2; and finally, the corresponding front board 21 is placed into the cabinet-level communication device 2, and a connector of the front board 21 is correspondingly connected to the first connector 11 of the backplane 1, so that the cabinet-level communication device 2 is installed.

Similarly, as shown in FIG. 4, first, the backplane 1 may also be fixed and arranged on the front board 21, and then, the rear board 22 is connected to the second connector 12 of the backplane 1 that is arranged on the front board 21, so that the cabinet-level communication device 2 is installed.

In the technical solutions of this embodiment, a backplane is provided. The backplane has a stripe structure and has a small size. No cooling hole needs to be arranged on the backplane, and heat dissipation can be implemented simply through the space between backplanes. This improves mechanical strength of the backplane and ensures a service life of the backplane while ensuring the effect of heat dissipation. In addition, the backplane is fixed and arranged in a detachable manner on the rear board or the front board and can be plugged or unplugged along with the rear board that fixes the backplane or the front board that fixes the backplane, thereby reducing difficulty in replacing the backplane. This further reduces difficulty in maintaining, by a user, a cabinet-level communication device provided with the backplane and reduces a maintenance cost, and improves use experience of the user.

### Embodiment 2

This embodiment of the present invention provides a backplane 1. The backplane 1 applies to a cabinet-level communication device. As shown in FIG. 1, the following are included:
a base plate 10 of a stripe structure;
one or more first connectors 11, where the first connector 11 is arranged on a first face of the base plate 10 and configured to connect a corresponding connector on a front board; and
one or more second connectors 12, where the second connector 12 is arranged on a second face of the base plate 10 opposite to the first face and configured to connect a corresponding connector on a rear board.

In this embodiment and the following embodiments, the base plate may be considered as a plate in a general sense and its material is not limited. For example, the base plate may be a PCB board or boards of other types (such as metal, wood, and compound material). The base plate may be considered as a hexahedron (because each board has a certain thickness), and the first face and the second face of the base plate are two flat surfaces having an obviously largest area among faces of the base plate. In addition, it should be noted that the first face and the second face are not necessarily on a physical media surface. In practice, the base plate may have some holes that thread through the first face and the second face, and the two surfaces having the largest area and the holes may still be considered as the first face and the second face.

The first connector and the second connector may be arranged as two independent connectors on the first face and the second face, respectively. Alternatively, the first connector and the second connector are made into an entire component, a mounting hole is opened on the base plate, and the entire component is placed in the mounting hole, so that the first connector and the second connector are located on the first face and the second face, respectively. A specific arranging method is a technology commonly known to a person of ordinary skill in the art, and no further details are provided herein.

In this embodiment, the rear board 22 is connected to the front board 21 in an orthogonal connection manner through the backplane 1. The connection may be a physical connection or an electrical connection, and cabling is arranged inside the backplane 1, so that functions such as data exchange and signal transfer can be implemented between the rear board 22 and the front board 21.

As shown in FIG. 2, generally, the backplane 1 in the prior art has a plate structure, and two or more columns of connectors are arranged on each face of the backplane 1. For ease of description, a face on which a first connector 11 is arranged is called the first face, and another face on which a second connector 12 is arranged is called the second face. The first connector 11 on the first face is configured to connect to a connector on the front board 21, and the second connector 12 on the second face is configured to connect a connector on the rear board 22. During installation, generally, the backplane 1 is first fixed and arranged on a shelf of a cabinet-level communication device 2, and then, the front board 21 and the rear board 22 are connected to corresponding connectors of the backplane 1, respectively, to implement a data connection between the front board 21 and the rear board 22.

In the technical solutions of the present invention, as shown in FIG. 1, the base plate of the backplane 1 has a stripe structure. The so-called stripe structure is a stripe structure compared with a backplane in the prior art. As can be seen from the comparison between FIG. 1 and FIG. 2, a length and a width of the backplane 1 shown in FIG. 1 according to the present invention are relatively large, and generally, a size of the first face of the backplane 1 according to the present invention allows only one column of the first connectors to be arranged; and similarly, a size of the second face of the backplane 1 according to the present invention allows only one column of the second connectors to be arranged. This is different from the backplane 1 in the prior art.

In addition, the backplane 1 is fixed and arranged in a detachable manner in advance on the rear board 22 or the front board 21, and then, can be plugged or unplugged along with the rear board 22 that fixes the backplane 1 or the front board 2 that fixes the backplane 1, instead of being installed on a shelf in the prior art, thereby simplifying installation steps of the backplane 1.

During installation, as shown in FIG. 3, first, the second connector 12 of the backplane 1 may be matched and connected to the corresponding connector on the rear board 22; then, the backplane 1 is fixed and arranged on the rear board 22 by using one or more fixtures (such as a screw, a bolt, or the like); then, the rear board 22 arranged with the backplane 1 is arranged in a corresponding position of the cabinet-level communication device 2; and finally, the corresponding front board 21 is placed into the cabinet-level communication device 2, and a connector of the front board 21 is correspondingly connected to the first connector 11 of the backplane 1, so that the cabinet-level communication device 2 is installed.

Similarly, as shown in FIG. 4, first, the backplane 1 may also be fixed and arranged on the front board 21, and then, the rear board 22 is connected to the second connector 12 of the backplane 1 that is arranged on the front board 21, so that the cabinet-level communication device 2 is installed.

Specifically, as shown in FIG. 3, when the backplane 1 is fixed and arranged on the rear board 22, the second connector 12 of the backplane 1 is connected to the corresponding connector on the rear board 22, and the rear board 22 and the backplane 1 are vertically placed in the cabinet-level communication device 2; and
in this case, the front board 21 is horizontally placed in the cabinet-level communication device 2, the backplane 1 is orthogonally connected to the front board 21, and the first connector 11 of the backplane 1 is connected to the corresponding connector on the front board 21;
or:
as shown in FIG. 4, when the backplane 1 is fixed and arranged on the front board 21, the first connector 11 of the backplane 1 is connected to the corresponding connector on the front board 21, and the front board 21 and the backplane 1 are horizontally placed in the cabinet-level communication device 2; and
in this case, the rear board 22 is vertically placed in the cabinet-level communication device 2, the backplane 1 is orthogonally connected to the rear board 22, and the second connector 12 of the backplane 1 is connected to the corresponding connector on the rear board 22.

Generally, when the front board 21 and the rear board 22 of the cabinet-level communication device 2 are working, plenty of heat is radiated. Therefore, in the prior art, generally, at least one cooling hole 13 of a varied size is arranged on the backplane 1, so that the heat can be rapidly dissipated to another place. Arranging the cooling hole 13, however, reduces the overall mechanical strength of the backplane 1 and causes the backplane 1 to be easily damaged, thereby affecting a service life of the backplane 1.

In the technical solutions of the present invention, the backplane 1 has a stripe structure and its size, especially a longitudinal size, is relatively small as compared with a backplane 2 in the prior art. As shown in FIG. 3, when multiple backplanes 1 are arranged between the front board 21 and the rear board 22 of the cabinet-level communication device 2, because the space between the backplanes 1 is large and can be used for heat dissipation of the cabinet-level communication device 2, no cooling hole needs to be arranged on the backplane 1 as compared with the prior art, thereby improving the mechanical strength of the backplane 1. This further improves the service life of the backplane 1, reduces a complexity requirement of the backplane 1 in terms of a production process, and lowers a manufacturing cost of the backplane 1.

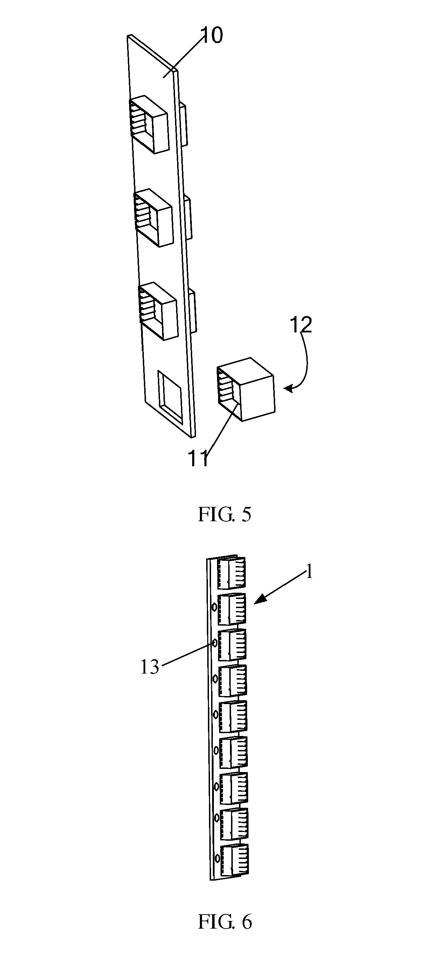

Generally, the first connector 11 and the second connector 12 are connectors independent of each other and separated from each other, and are connected through the cabling in the backplane 1 after being arranged on the backplane 1. However, the first connector 11 and the second connector 12 may also be integrated. As shown in FIG. 5, cabling may be arranged directly in the whole to provide a physical connection or an electrical connection between the first connector 11 and the second connector 12.

It should be noted that a face on which the first connector 11 is arranged on the backplane 1 is called the first face, and a face on which the second connector 12 is arranged is called the second face, as mentioned previously. When the first connector 11 and the second connector 12 are integrated, a hollow hole for matching the whole of the first connector 11 and the second connector 12 needs to be added at a corresponding position of the backplane 1, so as to install the first connector 11 and the second connector 12.

As shown in FIG. 6, a screw hole 13, which is used for fixing and arranging the backplane 1 on the rear board 22 or the front board 21 in a detachable manner, is opened on the backplane 1. After the first connector 11 of the backplane 1 is connected to the corresponding connector of the front board 21, or after the second connector 12 of the backplane 1 is connected to the corresponding connector of the rear board 22, the screw hole 13 on the backplane 1 may be used to fix and arrange the backplane 1 on the front board 21 or the rear board 22 through a screw or a bolt, so as to enhance the strength of combining the backplane 1 and the front board 21 or the rear board 22.

Generally, a matching relationship between the front board 21 or the rear board 22 and the cabinet-level communication device 2 is similar to a matching relationship between a drawer and a cabinet. That is, a slide rail is arranged on the cabinet-level communication device 2 to enable the front board 21 or the rear board 22 to be placed into the cabinet-level communication device 2, and a corresponding sliding wheel is arranged on the front board 21 and the rear board 22 as a device to match the slide rail, so that the front board 21 and the rear board 22 are quite conveniently installed. In the technical solutions of the present invention, because the backplane 1 is fixed and arranged in advance on the front board 21 or the rear board 22, the backplane 1 and the front board 21 or the rear board 22 is integrated. Then, the installation of the backplane 1 can be implemented after the backplane 1 and the front board 21 or the rear board 22 are placed together into the cabinet-level communication device 2, unlike the prior art in which the backplane 1 needs to be fixed on the cabinet-level communication device 2 first, thereby greatly reducing difficulty in installing the backplane 1.

During detachment, first, the front board 21 or the rear board 22 arranged with the backplane 1 needs to be taken out of the cabinet-level communication device 2, and then, the backplane 1 arranged on the front board 21 or the rear board 22 is detached, so that detachment of the backplane 1 can be implemented, unlike the prior art in which a shelf of the cabinet-level communication device 2 needs to be detached before the backplane 1 is detached, thereby reducing difficulty in detaching the backplane 1.

In sum, because a backplane 1 is installed and detached quite easily without requiring a professional person, a user can install and detach the backplane 1 on his or her own, thereby reducing difficulty in maintaining a cabinet-level communication device 2 arranged with the backplane 1 and reducing a maintenance cost and improving use experience of the user.

### Embodiment 3

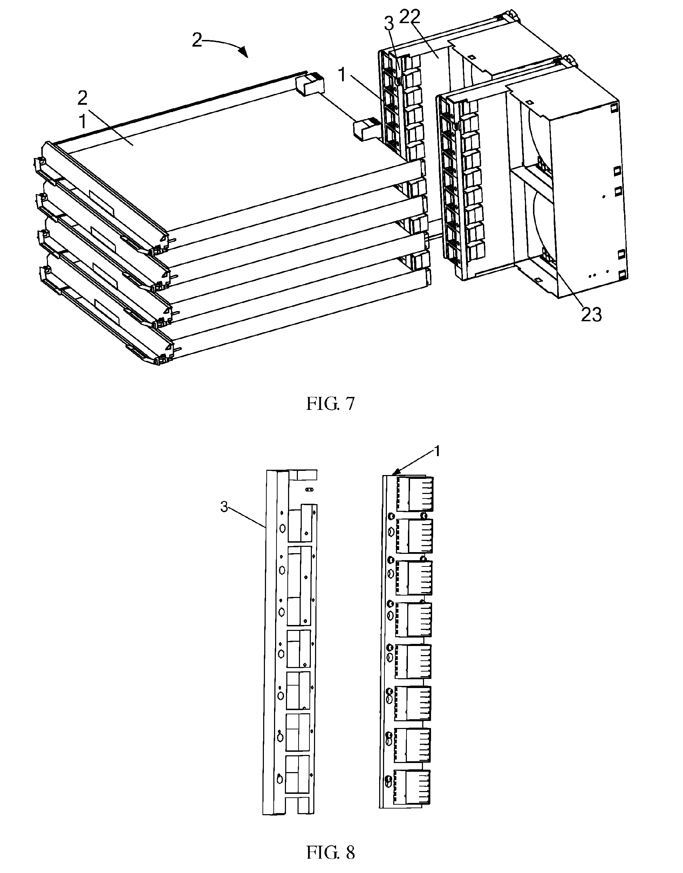

An embodiment of the present invention provides a cabinet-level communication device 2. As shown in FIG. 7, the cabinet-level communication device 2 includes a front board 21, a rear board 22, and a backplane 1. As shown in FIG. 1, the backplane 1 includes:
a base plate 10 of a stripe structure;
one or more first connectors 11, where the first connector 11 is arranged on a first face of the base plate 10 and configured to connect a corresponding connector on a front board; and
one or more second connectors 12, where the second connector 12 is arranged on a second face of the base plate 10 opposite to the first face and configured to connect a corresponding connector on a rear board.

The rear board is connected to the front board in an orthogonal connection manner through the backplane. The connection may be a physical connection or an electrical connection, and cabling is arranged inside the backplane 1, so that functions such as data exchange and signal transfer can be implemented between the rear board and the front board.

As shown in FIG. 2, generally, the backplane 1 in the prior art has a plate structure, and two or more columns of connectors are arranged on each face of the backplane 1. For ease of description, a face on which a first connector is arranged is called the first face, and another face on which a second connector is arranged is called the second face. The first connector 11 on the first face is configured to connect to a connector on the front board 21, and the second connector 12 on the second face is configured to connect a connector on the rear board 22. During installation, generally, the backplane 1 is first fixed and arranged on a shelf of a cabinet-level communication device 2, and then, the front board 21 and the rear board 22 are connected to corresponding connectors of the backplane 1, respectively, to implement a data connection between the front board 21 and the rear board 22.

In the technical solutions of the present invention, as shown in FIG. 1, the base plate of the backplane 1 has a stripe structure. The so-called stripe structure is a stripe structure compared with a backplane in the prior art. As can be seen from the comparison between FIG. 1 and FIG. 2, a length and a width of the backplane 1 shown in FIG. 1 according to the present invention are relatively large, and generally, a size of the first face of the backplane 1 according to the present invention allows only one column of the first connectors 11 to be arranged; and similarly, a size of the second face of the backplane 1 according to the present invention allows only one column of the second connectors 12 to be arranged. This is different from the backplane 1 in the prior art.

Specifically, connection relationships between the backplane 1, the front board 21, and the rear board 22 are as follows:

As shown in FIG. 3, when the backplane 1 is fixed and arranged on the rear board 22, the second connector 12 of the backplane 1 is connected to the corresponding connector on the rear board 22, and the rear board 22 and the backplane 1 are vertically placed in the cabinet-level communication device 2; and
in this case, the front board 21 is horizontally placed in the cabinet-level communication device 2, the backplane 1 is orthogonally connected to the front board 21, and the first connector of the backplane 1 is connected to the corresponding connector on the front board 21;
or:
as shown in FIG. 4, when the backplane 1 is fixed and arranged on the front board 21, the first connector 11 of the backplane 1 is connected to the corresponding connector on the front board 21, and the front board 21 and the backplane 1 are horizontally placed in the cabinet-level communication device 2; and
in this case, the rear board 22 is vertically placed in the cabinet-level communication device 2, the backplane 1 is orthogonally connected to the rear board 22, and the second connector 12 of the backplane 1 is connected to the corresponding connector on the rear board 22.

Generally, a position of the first connector 21 of the backplane 1 may be arranged correspondingly according to distribution of the front board 22. For example, as shown in FIG. 3, if the front board 22 located in a second layer from top to bottom is not arranged due to a certain reason, the first connector that is correspondingly connected to the front board 22 in the second layer may not be arranged on the backplane 1.

Similarly, a position of the second connector 22 of the backplane 1 may be arranged correspondingly according to distribution of the rear board 22.

In addition, the backplane 1 is fixed and arranged in a detachable manner in advance on the rear board 22 or the front board 21, and then, can be plugged or unplugged along with the rear board 22 that fixes the backplane 1 or the front board 2 that fixes the backplane 1, instead of being installed on a shelf in the prior art, thereby simplifying installation steps of the backplane 1.

During installation, as shown in FIG. 3, first, the second connector 12 of the backplane 1 may be matched and connected to the corresponding connector on the rear board 22; then, the backplane 1 is fixed and arranged on the rear board 22 by using one or more fixtures (such as a screw, a bolt, or the like); then, the rear board 22 arranged with the backplane 1 is arranged in a corresponding position of the cabinet-level communication device 2; and finally, the corresponding front board 21 is placed into the cabinet-level communication device 2, and a connector of the front board 21 is correspondingly connected to the first connector 11 of the backplane 1, so that the cabinet-level communication device 2 is installed.

Similarly, as shown in FIG. 4, first, the backplane 1 may also be fixed and arranged on the front board 21, and then, the rear board 22 is connected to the second connector 12 of the backplane 1 that is arranged on the front board 21, so that the cabinet-level communication device 2 is installed.

Generally, when the front board 21 and the rear board 22 of the cabinet-level communication device 2 are working, plenty of heat is radiated. Therefore, in the prior art, generally, at least one cooling hole 13 of a varied size is arranged on the backplane 1, so that the heat can be rapidly dissipated to another place. Arranging the cooling hole 13, however, reduces the overall mechanical strength of the backplane 1 and causes the backplane 1 to be easily damaged, thereby affecting a service life of the backplane 1.

In the technical solutions of the present invention, the backplane 1 has a stripe structure and its size, especially a longitudinal size, is relatively small as compared with a backplane 2 in the prior art. As shown in FIG. 3, when multiple backplanes 1 are arranged between the front board 21 and the rear board 22 of the cabinet-level communication device 2, because the space between the backplanes 1 is large and can be used for heat dissipation of the cabinet-level communication device 2, no cooling hole needs to be arranged on the backplane 1 as compared with the prior art, thereby improving the mechanical strength of the backplane 1. This further improves the service life of the backplane 1, reduces a complexity requirement of the backplane 1 in terms of a production process, and lowers a manufacturing cost of the backplane 1.

Generally, the first connector 11 and the second connector 12 are connectors independent of each other and separated from each other, and are connected through the cabling in the backplane 1 after being arranged on the backplane 1. However, the first connector 11 and the second connector 12 may also be integrated. As shown in FIG. 5, cabling may be arranged directly in the whole to provide a physical connection or an electrical connection between the first connector 11 and the second connector 12.

It should be noted that a face on which the first connector 11 is arranged on the backplane 1 is called the first face, and a face on which the second connector 12 is arranged is called the second face, as mentioned previously. When the first connector 11 and the second connector 12 are integrated, a hollow hole for matching the whole of the first connector 11 and the second connector 12 needs to be added at a corresponding position of the backplane 1, so as to install the first connector 11 and the second connector 12. In this case, a person of ordinary skill in the art may understand that the first face actually includes an entity face and a virtual face; and specifically, the entity face is a remaining flat part of the first face apart from the hole, the virtual face is a flat surface corresponding to the part of the hole, an area of the first face keeps unchanged, and similarly, the second face is like this.

As shown in FIG. 6, a screw hole 13, which is used for fixing and arranging the backplane 1 on the rear board 22 or the front board 21 in a detachable manner, is opened on the backplane 1. After the first connector 11 of the backplane 1 is connected to the corresponding connector of the front board 21, or after the second connector 12 of the backplane 1 is connected to the corresponding connector of the rear board 22, the screw hole 13 on the backplane 1 may be used to fix and arrange the backplane 1 on the front board 21 or the rear board 22 through a screw or a bolt, so as to enhance the strength of combining the backplane 1 and the front board 21 or the rear board 22.

Generally, a matching relationship between the front board 21 or the rear board 22 and the cabinet-level communication device 2 is similar to a matching relationship between a drawer and a cabinet. That is, a slide rail is arranged on the cabinet-level communication device 2 to enable the front board 21 or the rear board 22 to be placed into the cabinet-level communication device 2, and a corresponding sliding wheel is arranged on the front board 21 and the rear board 22 as a device to match the slide rail, so that the front board 21 and the rear board 22 are quite conveniently installed. In the technical solutions of the present invention, because the backplane 1 is fixed and arranged in advance on the front board 21 or the rear board 22, the backplane 1 and the front board 21 or the rear board 22 is integrated. Then, the installation of the backplane 1 can be implemented after the backplane 1 and the front board 21 or the rear board 22 are placed together into the cabinet-level communication device 2, unlike the prior art in which the backplane 1 needs to be fixed on the cabinet-level communication device 2 first, thereby greatly reducing difficulty in installing the backplane 1.

During detachment, first, the front board 21 or the rear board 22 arranged with the backplane 1 needs to be taken out of the cabinet-level communication device 2, and then, the backplane 1 arranged on the front board 21 or the rear board 22 is detached, so that detachment of the backplane 1 can be implemented, unlike the prior art in which a shelf of the cabinet-level communication device 2 needs to be detached before the backplane 1 is detached, thereby reducing difficulty in detaching the backplane 1.

In sum, because a backplane 1 is installed and detached quite easily without requiring a professional person, a user can install and detach the backplane 1 on his or her own, thereby reducing difficulty in maintaining a cabinet-level communication device 2 arranged with the backplane 1 and reducing a maintenance cost and improving use experience of the user.

As shown in FIG. 7, the cabinet-level communication device 2 further includes:
a metal support 3, where a through hole is opened on the metal support 3 to match the first connector 11 or the second connector 12 of the backplane 1; several screw holes 31 are further opened on the metal support 3 to fix and connect the backplane 1 and the front board 21 or the rear board 22; and the metal support 2 is configured to fix and arrange the backplane 1 on the front board 21 or the rear board 22.

The metal support 3 may be arranged between the backplane 1 and the front board 21 or the rear board 22, so that the backplane 1 is more firmly fixed with the front board 21 or the rear board 22 and the backplane 1 is not easily damaged when being fixed on the front board 21 or the rear board 22.

As shown in FIG. 8, a connection between the metal support 3 and the backplane 1 and a connection between the metal support 3 and the front board 21 or the rear board 22 are generally fixed through one or more fixtures, where a screw or a bolt is a most common fixture. Therefore, generally, a screw hole is opened on the metal support 3.

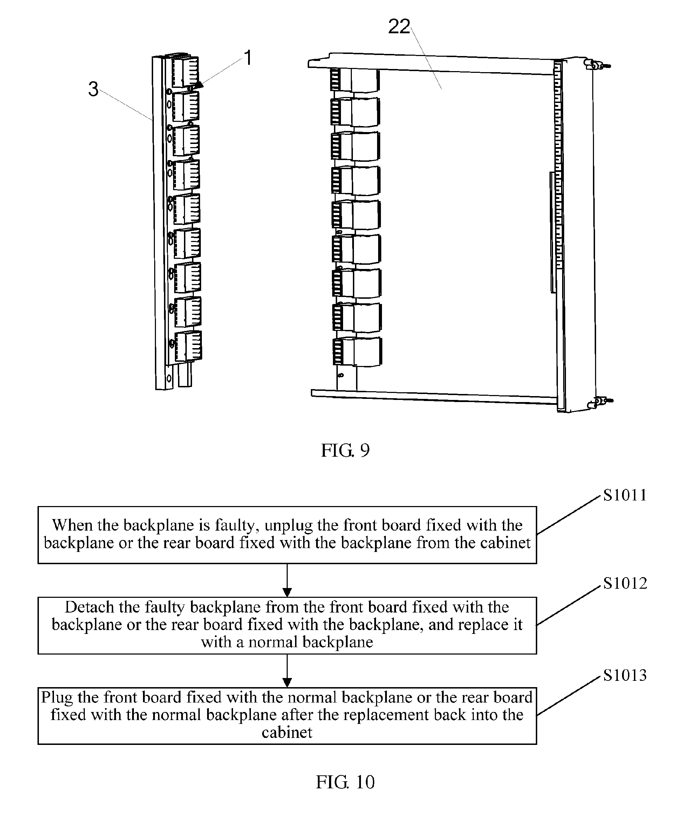

As shown in FIG. 9, during installation of the backplane 1, first, the backplane 1 needs to be fixed and arranged on the metal support 3, so that the backplane 1 and the metal support 3 are integrated; and then, the backplane 1 and the metal support 3 are together installed on the front board 21 or the rear board 22, and further arranged together with the front board 21 or the rear board 22 in the cabinet-level communication device 2.

On the contrary, during detachment of the backplane 1, first, the front board 21 or the rear board 22 arranged with the backplane 1 is taken out of the cabinet-level communication device 2; then, the backplane 1 and the metal support 3 are detached together from the front board 21 or the rear board 22; and finally, the backplane 1 is separated from the metal support 3.

Generally, as shown in FIG. 3, multiple fans 23 are further arranged on the cabinet-level communication device 2 so as to achieve the better effect of heat dissipation of the cabinet-level communication device 2.

In the technical solutions of this embodiment, a cabinet-level communication device is provided. The cabinet-level communication device includes a backplane. The backplane has a stripe structure and has a small size. No cooling hole needs to be arranged on the backplane, and heat dissipation can be implemented simply through the space between backplanes. This improves mechanical strength of the backplane and ensures a service life of the backplane while ensuring the effect of heat dissipation. In addition, the backplane is fixed and arranged in a detachable manner on the rear board or the front board and can be plugged or unplugged along with the rear board that fixes the backplane or the front board that fixes the backplane, thereby reducing difficulty in replacing the backplane. This further reduces difficulty in maintaining, by a user, the cabinet-level communication device and reduces a maintenance cost, and improves use experience of the user.

### Embodiment 4

An embodiment of the present invention provides a method for replacing a backplane. The method applies to a cabinet-level communication device 2. The communication device 2 includes: a cabinet, and a front board 21, a rear board 22, and a backplane 1 as described in Embodiment 2 inside the cabinet, where the front board 21 and the rear board 22 are connected through the backplane 1. As shown in FIG. 10, the method includes the following:

Step S1011: When the backplane 1 is faulty, unplug the front board 21 fixed with the backplane 1 or the rear board 22 fixed with the backplane 1 from the cabinet.

Step S1012: Detach the faulty backplane 1 from the front board 21 fixed with the backplane 1 or the rear board 22 fixed with the backplane 1, and replace it with a normal backplane 1.

Step S1013: Plug the front board 21 fixed with the normal backplane 1 or the rear board 22 fixed with the normal backplane 1 after the replacement back into the cabinet.

In the technical solutions of this embodiment, a method for replacing a backplane is provided. The method for replacing a backplane features a simple operation and a small number of steps, and a user can replace the backplane on his or her own without needing any help of a professional person, thereby reducing a cost of maintaining a cabinet-level communication device arranged with the backplane and improving use experience of the user.

The foregoing description is merely about specific embodiments of the present invention, but is not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A backplane, wherein the backplane applies to a cabinet-level communication device and comprises:
a base plate of a stripe structure;
one or more first connectors, wherein the first connector is arranged on a first face of the base plate and configured to connect a corresponding connector on a front board; and
one or more second connectors, wherein the second connector is arranged on a second face of the base plate opposite to the first face and configured to connect a corresponding connector on a rear board; and
the backplane is fixed and arranged in a detachable manner on the rear board or the front board and can be plugged or unplugged along with the rear board that fixes the backplane or the front board that fixes the backplane.

2. The backplane according to claim 1, wherein:
the backplane is fixed and arranged on the rear board, the second connector of the backplane is connected to the corresponding connector on the rear board, and the rear board and the backplane are vertically placed in the cabinet-level communication device; and
the front board is horizontally placed in the cabinet-level communication device, the backplane is orthogonally connected to the front board, and the first connector of the backplane is connected to the corresponding connector on the front board.

3. The backplane according to claim 1, wherein:
the backplane is fixed and arranged on the front board, the first connector of the backplane is connected to the corresponding connector on the front board, and the front board and the backplane are horizontally placed in the cabinet-level communication device; and
the rear board is vertically placed in the cabinet-level communication device, the backplane is orthogonally connected to the rear board, and the second connector of the backplane is connected to the corresponding connector on the rear board.

4. The backplane according to any one of claims 1 to 3, wherein:
the first connector and the second connector form an entire component, the base plate comprises a mounting hole, and the entire component is located in the mounting hole.

5. The backplane according to any one of claims 1 to 4, wherein:
a screw hole is opened on the backplane to fix and arrange the backplane in a detachable manner on the rear board or the front board.

6. The backplane according to any one of claims 1 to 5, wherein:
the rear board is connected to the front board in an orthogonal connection manner through the backplane.

7. A cabinet-level communication device, comprising a front board, a rear board, and a backplane, wherein the backplane comprises:
a base plate of a stripe structure;
one or more first connectors, wherein the first connector is arranged on a first face of the base plate and configured to connect a corresponding connector on a front board; and
one or more second connectors, wherein the second connector is arranged on a second face of the base plate opposite to the first face and configured to connect a corresponding connector on a rear board;
the backplane is fixed and arranged in a detachable manner on the rear board or the front board and can be plugged or unplugged along with the rear board that fixes the backplane or the front board that fixes the backplane; and
the rear board is connected to the front board through the backplane.

8. The cabinet-level communication device according to claim 7, wherein:
when the backplane is fixed and arranged on the rear board, the second connector of the backplane is connected to the corresponding connector on the rear board, and the rear board and the backplane are vertically placed in the cabinet-level communication device; and
the front board is horizontally placed in the cabinet-level communication device, the backplane is orthogonally connected to the front board, and the first connector of the backplane is connected to the corresponding connector on the front board.

9. The cabinet-level communication device according to claim 8, wherein:
a position of each first connector on the backplane corresponds to a position of each front board.

10. The cabinet-level communication device according to claim 7, wherein:
when the backplane is fixed and arranged on the front board, the first connector of the backplane is connected to the corresponding connector on the front board, and the front board and the backplane are horizontally placed in the cabinet-level communication device; and
the rear board is vertically placed in the cabinet-level communication device, the backplane is orthogonally connected to the rear board, and the second connector of the backplane is connected to the corresponding connector on the rear board.

11. The cabinet-level communication device according to claim 10, wherein:
a position of each second connector on the backplane corresponds to a position of each rear board.

12. The cabinet-level communication device according to any one of claims 7 to 8, wherein:
the first connector and the second connector form an entire component, the base plate comprises a mounting hole, and the entire component is located in the mounting hole.

13. The cabinet-level communication device according to claims 7 to 12, wherein:
a screw hole is opened on the backplane to fix and arrange the backplane in a detachable manner on the rear board or the front board.

14. The cabinet-level communication device according to claim 7, wherein the backplane further comprises multiple small holes that allow bolts of screws to pass through but do not allow nuts of the screws to pass through, and the cabinet-level communication device further comprises:
a metal support comprising multiple through holes and configured to enable the first connector or the second connector to pass through the through holes;
the metal support further comprises multiple screw holes configured to match the screws that pass through the small holes on the backplane, so as to fix the backplane and the metal support together; and
the metal support is fixed and arranged in a detachable manner on the front board or the rear board, so that the backplane is fixed and arranged in a detachable manner on the front board or the rear board.

15. The cabinet-level communication device according to any one of claims 7 to 14, wherein:
the rear board is connected to the front board in an orthogonal connection manner through the backplane.

16. A method for replacing a backplane, wherein the method applies to a cabinet-level communication device; the communication device comprises a cabinet, and a front board, a rear board, and a backplane inside the cabinet; the front board and the rear board are connected through the backplane; and the method comprises:
when the backplane is faulty, unplugging the front board fixed with the backplane or the rear board fixed with the backplane from the cabinet;
detaching the faulty backplane from the front board fixed with the backplane or the rear board fixed with the backplane, and replacing it with a normal backplane; and
plugging the front board fixed with the normal backplane or the rear board fixed with the normal backplane after the replacement back into the cabinet.
